# EUROPEAN PATENT APPLICATION

(11) **EP 2 423 701 A1**
(43) Date of publication of application: **29.02.2012**
(21) Application number: 10174604.8
(22) Date of filing: 31.08.2010
(51) Int. Cl.: G01R 33/561

(54) **Cardiac ultra-short echo time MRI**

(71) Applicant: Koninklijke Philips Electronics N.V., 5621 BA Eindhoven (NL)
(72) Inventor: Luijten, Peter, R., 5600 AE Eindhoven (NL); Visser, Fredy, 5600 AE Eindhoven (NL); Zwanenburg, Jaco, J.,M., 5600 AE Eindhoven (NL)
(74) Representative: Damen, Daniel Martijn

(57) **Abstract**

The invention relates to a method of performing magnetic resonance imaging for direct detection of fibrosis in a heart, the method comprising performing the magnetic resonance imaging scan using an ultra-short echo time acquisition pulse sequence applied to the region of interest of the heart for spin excitation in the region of interest.

## Description

### FIELD OF THE INVENTION

The invention relates to a method of performing magnetic resonance imaging (MRI) for direct detection of fibrosis in the cardio-vascular system, a computer program product and an MRI system.

### BACKGROUND OF THE INVENTION

Image-forming MR methods, which utilize the interaction between magnetic field and nuclear spins in order to form two-dimensional or three-dimensional images are widely used nowadays, notably in the field of medical diagnostics, because for the imaging of soft tissue they are superior to other imaging methods in many respects, they do not require ionizing radiation, and they are usually not invasive. MRI is used for example as imaging technique to visualize myocardial injury. Cardiac and respiratory triggered MR imaging can be used to image morphology, time resolved cine movies may reveal cardiac function, dynamic contrast enhanced imaging can be utilized to measure perfusion and MR tagging sequences can be used to study the contraction of the myocardium in detail.

According to the MR method in general, the body of a patient or in general an object to be examined is arranged in a strong, uniform magnetic field B0 whose direction at the same time defines an axis, normally the z-axis, of the coordinate system on which the measurement is based.

The magnetic field produces different energy levels for the individual nuclear spins in dependence on the applied magnetic field strength which spins can be excited (spin resonance) by application of an alternating electromagnetic field (RF field) of defined frequency, the so called Larmor frequency or MR frequency. From a macroscopic point of view the distribution of the individual nuclear spins produces an overall magnetization which can be deflected out of the state of equilibrium by application of an electromagnetic pulse of appropriate frequency (RF pulse) while the magnetic field extends perpendicularly to the z-axis, so that the magnetization performs a precessional motion about the z-axis.

Any variation of the magnetization can be detected by means of receiving RF antennas, which are arranged and oriented within an examination volume of the MR device in such a manner that the variation of the magnetization is measured in the direction perpendicularly to the z-axis.

In order to realize spatial resolution in the body, switching magnetic field gradients extending along the three main axes are superposed on the uniform magnetic field, leading to a linear spatial dependency of the spin resonance frequency. The signal picked up in the receiving antennas then contains components of different frequencies which can be associated with different locations in the body.

The signal data obtained via the receiving antennas corresponds to the spatial frequency domain and is called k-space data. The k-space data usually includes multiple lines acquired with different phase encoding. Each line is digitized by collecting a number of samples. A set of samples of k-space data is converted to an MR image, e.g. by means of Fourier transformation.

Assessment of myocardial injury after ischemia is an important predictive parameter for clinical outcome. The standard technique currently looking for myocardial viability is the delayed enhancement technique which allows for the detection of both necrosis and fibrosis of the myocardium. In regions of myocardial fibrosis or necrosis, the number of intact myocytes is decreased resulting in an increased percentage of interstitial space per unit volume compared with normal myocardial tissue. Originally, the technique has been developed for characterization of myocardial scarring after myocardial infarction (Pennell,D.J. et al. Clinical indications for cardiovascular magnetic resonance (CMR): Consensus Panel report. J. Cardiovasc. Magn Reson. 6, 727-765 (2004)). Using this technique, scar tissue or fibrosis can be visualized by means of a hyperintense signal, typically subendocardial or transmural in a coronary artery distribution

However, gadolinium uptake in the interstitial space is non specific and cannot discriminate between many different forms of cardiac diseases. Moreover, timing of the experiment (timing of the MRI exam after contrast agent administration) is critical as a too short delay may result in insufficient washout of the contrast agents in normal myocardium resulting in an overestimation of the extension of the scarred tissue, whereas a too long delay will result in poor signal to noise and ultimately an underestimation of the scarred tissue.

For a better prediction of clinical outcome and assessment or monitoring of applied therapies it would be beneficial to be able to determine the extent of upregulated collagen synthesis in the affected region that will be triggered by the ischemic injury. This excessive production of collagen is called fibrosis - the synthesis of (primarily type I) collagen as a result of a reparative or reactive process. The generation of fibrotic tissue in the myocardium will result in left ventricular (LV) remodeling, which ultimately may result in heart failure. Progression of fibrotic tissue and concomitant LV remodeling takes place during a period of weeks to several months after the cardiac ischemic event.

From the foregoing it is readily appreciated that there is a need for an improved imaging method. It is consequently an object of the invention to provide an improved magnetic resonance imaging method of performing magnetic resonance imaging for direct detection of post infarction collagen formation in a heart.

### SUMMARY OF THE INVENTION

In accordance with the invention, a method of performing magnetic resonance imaging for direct detection of fibrosis in the cardio-vascular system is provided, the method comprising performing the magnetic resonance imaging scan using an ultra-short echo time acquisition pulse sequence applied to the region of interest of the heart. For example, the fibrosis is due to post infarction collagen formation. However, it has to be noted that generally collagen formation can also take place after myocarditis and is observed in patients with heart failure (Trends Cardiovasc Med. 2009 Nov;19(8):247-52, 'Mechanisms of cardiac fibrosis in inflammatory heart disease', Kania G, Blyszczuk P, Eriksson U.).

Embodiments of the invention have the advantage, that the viability of the investigated tissue can be directly assessed without the need for late enhancement studies that require for example Gd-based contrast agents. To monitor the progression of fibrosis, it is thus possible to use a much more direct detection methodology rather than using delayed enhancement MRI which may result in (hyper)enhancement in all kinds of scar tissue, as well as in inflammation, infection of the myocardium, cardiomyopathy, cardiac neoplasms and congenital or genetic cardiac conditions.

The pulse sequence used utilizes the fact that protons in exchange with a matrix of connective or fibrotic tissue have substantially shorter T1 and T2 relaxation times than most other (soft) tissues. It is known that that sequences with extreme short echo times (UTE) can detect more "solid" tissue components, characterized by short T2 relaxation properties (Clinical Radiology, 58 (2003) 1-19). However, these techniques have only been used to image cartilage, menisci, ligaments, tendons, cortical and trabecular boine, periosteum and the myelin water in white matter.

In contrast, the present invention suggests to perform direct detection of post infarction collagen formation in a heart using ultra-short echo time acquisition pulse sequences. This permits to perform in vivo imaging of protons associated with fibrosis in myocardial or other tissues. Up to now, in vivio imaging was considered a being impossible with respect to cardiac imaging of protons associated with fibrosis in myocardial or other tissues. State of the art late enhancement studies that require for example Gd-based contrast agents did not permit a reliable in vivo imaging on collagen formation in the heart.

In accordance with an embodiment of the invention, the ultra-short echo time acquisition pulse sequence is a gradient echo pulse sequence and/or a spin echo pulse sequence.

In accordance with a further embodiment of the invention, the echo time is below 200µs. Thus, the requirements regarding short T2 values typically occurring in fibrotic tissue are met.

In accordance with an embodiment of the invention, the ultra-short echo time acquisition pulse sequence is applied to the myocardium for detection of post infarction collagen formation in the myocardium. Thus, viability of myocardial tissue after infarction can be directly assessed in a reliable manner.

In accordance with a further embodiment of the invention, the method further comprises performing a quantitative assessment of the collagen formation. This is possible since the above described method does not depend on a time dependent varying uptake of a contrast agent to be imaged. Instead, directly the collagen formation is imaged. Quantitative assessment of the collagen formation may be performed using for example prior calibration processes of the MR system used for performing the MR imaging method. Thus, rather than using the indirect method of delayed enhancement which cannot be used for quantitative information, applying the ultra-short echo time acquisition pulse sequence to the region of interest of the heart permits to obtain in an easy manner a quantitative assessment of the collagen formation in the region of interest.

In accordance with an embodiment of the invention, the method further comprises applying a collagen-targeting contrast agent. The quest for a specific method for collagen imaging in the heart has triggered the development of a number of new molecular imaging agents that specifically bind to collagen. An example is EP-3533, a collagen targeting contrast agent comprising a collagen binding peptide conjugated with gadolinium for positive contract enhancement (Helm, P.A. et al. Postinfarction myocardial scarring in mice: molecular MR imaging with use of a collagen-targeting contrast agent. Radiology 247, 788-796 (2008)).

In another aspect, the invention relates to a computer program product comprising computer executable instructions to perform the method steps as described above.

In another aspect, the invention relates to a magnetic resonance imaging system for direct detection of fibrosis in the cardio-vascular system, the system comprising:
- a main magnet for generating a uniform, steady magnetic field within an examination volume,
- a controller for controlling the generation of an ultra-short echo time acquisition pulse sequence to be applied to a region of interest of the heart for spin excitation in the region of interest,
- at least one RF antenna for transmitting RF pulses of the pulse sequence to the examination volume for magnetic resonance spin excitation,
- a receiver for receiving RF signals resultant from the spin excitation,
- a reconstruction unit for reconstructing a magnetic resonance image from the received RF signals.

### BRIEF DESCRIPTION OF THE DRAWINGS

The enclosed drawings disclose preferred embodiments of the invention. It should be understood, however, that the drawings are designed for the purpose of illustration only and not as a definition of the limits of the invention. In the drawings:
Fig. 1 illustrates a schematic of an MR device according to the invention,
Fig. 2 shows a result of an MR ultra-short echo time acquisition pulse sequence applied to a region of interest of the heart.

### DETAILED DESCRIPTION OF THE DRAWINGS

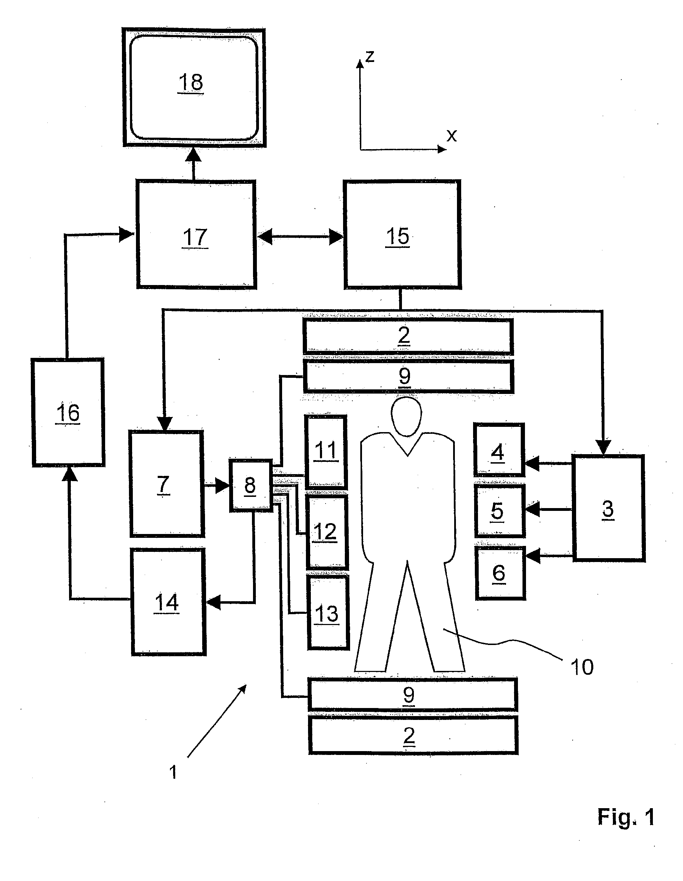

With reference to Fig. 1, an MR imaging system 1 is shown. The system comprises superconducting or resistive main magnet coils 2 such that a substantially uniform, temporarily constant main magnetic field B₀ is created along a z-axis through an examination volume.

The magnetic resonance system applies a series of RF pulses and switched magnetic field gradients to invert or excite nuclear magnetic spins, induce magnetic resonance, refocus magnetic resonance, manipulate magnetic resonance, spatially or otherwise encode the magnetic resonance, saturate spins and the like to perform MR imaging.

More specifically, a gradient pulse amplifier 3 applies current pulses to selected ones of whole body gradient coils 4, 5 and 6 along x, y and z-axes of the examination volume. An RF transmitter 7 transmits RF pulses or pulse packets, via a send/receive switch 8 to an RF antenna 9 to transmit RF pulses into the examination volume. A typical MR imaging sequence is composed of a packet of RF pulse sequences of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals may also be picked up by the RF antenna 9.

For generation of MR images of limited regions of the body or in general object 10, for example by means of parallel imaging, a set of local array RF coils 11, 12 and 13 are placed contiguous to the region selected for imaging. The array coils 11, 12 and 13 can be used to receive MR signals induced by RF transmissions effected via the RF antenna. However, it is also possible to use the array coils 11, 12 and 13 to transmit RF signals to the examination volume.

The resultant MR signals are picked up by the RF antenna 9 and/or by the array of RF coils 11, 12 and 13 and are demodulated by a receiver 14 preferably including a pre-amplifier (not shown). The receiver 14 is connected to the RF coils 9, 11, 12 and 13 via a send/receive switch 8.

A host computer 15 controls the gradient pulse amplifier 3 and the transmitter 7 to generate any of a plurality of imaging sequences, such as echo planar imaging (EPI), echo volume imaging, gradient and spin echo imaging, fast spin echo imaging, imaging using ultra-short echo time acquisition pulse sequences and the like.

For the selected sequence, the receiver 14 receives a single or a plurality of MR data lines in a rapid succession following each RF excitation pulse. A data acquisition system 16 performs analogue to digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume or the like. The image is then stored in an image memory where it may be accessed for converting slices or other portions of the image representation into appropriate formats for visualization, for example via a video monitor 18 which provides a man readable display of the resultant MR image.

To date, there is no adequate imaging technique that can be used for the direct detection of increased collagen formation and its concomitant left ventricular (LV) remodeling in man. However, according to the invention the ultra short TE MRI technology can be used for the direct detection of post infarction collagen formation. To validate the technique, the MR images have been cross referenced with histology to confirm collagen detection and exclude other signal sources associated with the model.

It has to be noted that the detection of ischemic injury by measuring collagen formation may not be the only application of this technique. Fibrosis in other organs may become an interesting application, as well as the measurement of collagen formation during tissue repair of in regenerative medicine or monitoring physiologic changes after organ transplants.

The relaxation mechanism for protons associated with collagen are related to chemical exchange between water protons and exchangeable collagen protons for T2, whereas cross-relaxation is the determinant mechanism for the T1 in hydrated collagen. Values reported for different water fractions range from 10 to 426 ms, where the majority of the water fraction has a T2 value between 10 and 50 ms (Traore, A., Foucat, L., & Renou, J.P. 1H-nmr study of water dynamics in hydrated collagen: transverse relaxation-time and diffusion analysis. Biopolymers 53, 476-483 (2000)). Depending on the field strength being used, T2* will be substantially shorter than these reported values which is being used in the current application of MR imaging for direct detection of post infarction collagen formation in a heart.

The proof of principle has been tested in a rat model. An Ischemic injury was applied to a rat by clamping the LAD. Fibrosis will results in substantial collagen deposits after approximately 6 weeks of recovery, after which the animal is sacrificed and the heart being imaged (at 7.0 T, using a home made surface Tx/Rx coil). After MRI, histology has been performed on selected slices.

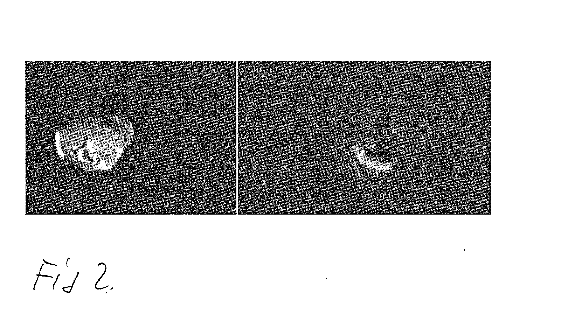

Figure 2 shows the anatomical image (left) and the subtraction image (right). The right (weighted) subtraction image of the two native signals was obtained at TE= 130 and 6000 µs respectively. It has to be noted, that the signal to noise could be further optimized for the selective detection of collagen. Spatial resolution is 350 µm (isotropic). The origin of the hyperintense MRI signal in the right image has further been successfully validated by histology. The corresponding slice has been stained both for collagen (Sirius Red) and iron to exclude any hyperintense signal from blood products (hemosedirin).

Advantages of the direct visualization of fibrosis/collagen over existing non-invasive techniques are that the method permits to directly detect collagen and could thus be used for a quantitative assessment of collagen rather than using the indirect method of delayed enhancement which cannot be used for quantitative information. Further, the method can be used in longitudinal studies to assess the LV modeling over time and the method can be applied with sufficient spatial resolution to differentiate between endo- and epi-cardial layers, potentially an important parameter for ablation guidance.

Generally, the method can be performed without the need for exogenous contrast agents. The spatial resolution can even be improved using higher field strengths, providing a window of opportunity to discriminate between replacement (scar) fibrosis and interstitial (reactive) fibrosis which may have an impact on the therapy of choice.

## Claims

1. A method of performing magnetic resonance imaging for direct detection of fibrosis in the cardio-vascular system, the method comprising performing the magnetic resonance imaging scan using an ultra-short echo time acquisition pulse sequence applied to the region of interest of the heart for spin excitation in the region of interest.

2. The method of claim 1, wherein the echo time acquisition pulse sequence is a gradient echo pulse sequence and/or a spin echo pulse sequence.

3. The method of claim 1, wherein the echo time is below 200 µs.

4. The method of claim 1, wherein the ultra-short echo time acquisition pulse sequence is applied to the myocardium for detection of post infarction collagen formation in the myocardium.

5. The method of claim 1, further comprising performing a quantitative assessment of the collagen formation.

6. The method of claim 1, further comprising applying a collagen-targeting contrast agent.

7. The method of claim 1, wherein the imaging is performed in vivo.

8. A computer program product comprising computer executable instructions to perform the method steps as claimed in the previous claims.

9. A magnetic resonance imaging system (1) for direct detection of fibrosis in the cardio-vascular system, the system comprising:
- a main magnet (2) for generating a uniform, steady magnetic field within an examination volume,
- a controller (15) for controlling the generation of an ultra-short echo time acquisition pulse sequence to be applied to a region of interest of the heart for spin excitation in the region of interest,
- at least one RF antenna (9) for transmitting RF pulses of the pulse sequence to the examination volume for magnetic resonance spin excitation,
- a receiver (14) for receiving RF signals resultant from the spin excitation,
- a reconstruction unit (17) for reconstructing a magnetic resonance image from the received RF signals.
